# FASCICULE DE BREVET EUROPEEN

(11) **EP 1 647 169 B1**
(45) Date de publication et mention de la délivrance du brevet: **11.11.2009**
(21) Numéro de dépôt: 04732596.4
(22) Date de dépôt: 13.05.2004
(51) Int. Cl.: H05K 7/14, H05K 5/00

(54) **BOITIER, NOTAMMENT BOITIER DESTINE A CONTENIR DES COMPOSANTS ELECTRONIQUES OU SIMILAIRES**
GEHÄUSE, INSBESONDERE GEHÄUSE ZUR AUFNAHME VON ELEKTRONISCHEN BAUTEILEN ODER DERGLEICHEN
HOUSING, IN PARTICULAR HOUSING FOR ELECTRONIC COMPONENTS OR THE LIKE

(30) Priorité: 23.07.2003 FR 0308963
(43) Date de publication de la demande: 19.04.2006
(73) Titulaire: Continental Automotive France, 31100 Toulouse (FR)
(72) Inventeur: LOUCHART, Gautier, F-91400 Gometz La Ville (FR)
(74) Mandataire: Bonn, Roman Klemens
(86) Numéro de dépôt international: PCT/EP2004/005135
(87) Numéro de publication internationale: WO 2005/009097

(56) Documents cités:
- CA-C- 2 025 698
- FR-A- 2 682 005
- US-A- 5 111 362
- US-A1- 2001 028 555

## Description

La présente invention concerne un boîtier, notamment un boîtier destiné à contenir des composants électriques ou similaires, par exemple montés sur un circuit imprimé (appelé aussi en anglais Printed Circuit Board ou PCB) ou similaire.

Il est connu, notamment dans le domaine de l'électronique, d'utiliser un boîtier métallique à l'intérieur duquel se trouvent des composants électroniques placés sur un circuit imprimé. Ce boîtier comporte un couvercle qui peut être constitué éventuellement par le circuit imprimé. Le couvercle est vissé sur le boîtier de manière à venir fermer celui-ci de manière réversible. Souvent, les vis utilisées sont des vis générant elles-mêmes leur taraudage lors du vissage, telles que des vis autotaraudeuses ou autoformeuses. Lors de leur vissage, des copeaux sont produits et ceux-ci tombent à l'intérieur du boîtier, la vis étant introduite depuis l'extérieur de celui-ci. Les copeaux ainsi réalisés tombent parfois sur le circuit imprimé. Ils peuvent alors créer entre les pattes des composants électroniques se trouvant sur le circuit imprimé, ou entre deux pistes de ce circuit, un court-circuit. Ainsi un copeau peut rendre un dispositif électronique inutilisable.

Les composants étant maintenant implantés sur les circuits imprimés de plus en plus près les uns des autres, les problèmes de courts-circuits créés par des copeaux sont de plus en plus fréquents et deviennent donc de moins en moins admissibles.

La présente invention a alors pour but de fournir un boîtier qui, par sa conception, empêche un copeau d'atteindre le circuit imprimé destiné à prendre place à l'intérieur de celui-ci. De préférence, le boîtier proposé ne présente pas de surcoût sensible par rapport à un boîtier de l'art antérieur.

A cet effet, elle propose un boîtier métallique, notamment un boîtier destiné à contenir des composants électroniques ou similaires, comportant une paroi latérale munie d'un rebord présentant un alésage pour recevoir une vis de fixation.

Selon l'invention, la paroi latérale présente, au niveau de l'alésage, une zone en creux dont la concavité est orientée vers l'extérieur du boîtier, le rebord destiné à recevoir la vis surplombant la zone en creux.

Avec un tel boîtier, lorsque la vis est vissée dans le rebord, la tige de la vis ayant traversé le rebord vient dans la zone en creux, à l'extérieur du boîtier, entraînant avec elle les éventuels copeaux formés lors du vissage. Ces copeaux sont donc entraînés vers l'extérieur du boîtier et ne peuvent donc pas polluer les composants électroniques, ou autres, se trouvant à l'intérieur de celui-ci.

Pour que les dimensions externes du boîtier selon l'invention restent inchangées par rapport à un boîtier similaire de l'art antérieur (c'est-à-dire un boîtier renfermant les mêmes composants), si la paroi latérale est sensiblement plane, alors on prévoit que le rebord surplombant ne traverse pas le plan de la paroi.

Quand la paroi latérale est sensiblement plane alors le rebord surplombant est de préférence sensiblement perpendiculaire au plan de la paroi. La vis reçue dans le rebord s'étend alors sensiblement parallèlement à la paroi.

Pour faciliter l'évacuation des copeaux hors du boîtier et les éloigner de celui-ci, quand la paroi latérale est sensiblement plane, on prévoit avantageusement que la zone en creux présente une surface inclinée par rapport au plan de la paroi latérale de manière à évacuer vers l'extérieur du boîtier d'éventuels copeaux produits par le vissage de la vis de fixation. Dans cette forme de réalisation, la surface inclinée est avantageusement raccordée au rebord surplombant par une portion de paroi sensiblement parallèle à la paroi latérale. Cette portion de paroi parallèle à la paroi latérale se trouve, lorsque la vis de fixation est en place, à la hauteur de la tige de la vis de fixation et est parallèle à cette tige de vis, dans la mesure où le rebord est perpendiculaire à la paroi latérale. Cet agencement permet de limiter l'espace occupé à l'intérieur du boîtier par la zone en creux et d'éviter que la vis ne vienne endommager la paroi de la zone en creux dans laquelle sa tige vient loger.

Dans une forme de réalisation d'un boîtier selon l'invention, ce dernier comporte un capot métallique formant couvercle, les composants électroniques ou similaires sont portés par un circuit imprimé, et le bord périphérique du circuit imprimé est pris en sandwich entre le capot et le rebord destiné à recevoir la vis de fixation, cette dernière traversant le circuit imprimé.

Des détails et avantages de la présente invention ressortiront mieux de la description qui suit, faite en référence au dessin schématique annexé sur lequel :
La figure 1 est une vue en perspective d'un boîtier selon l'invention,
La figure 2 est une vue de face du boîtier de la figure 1,

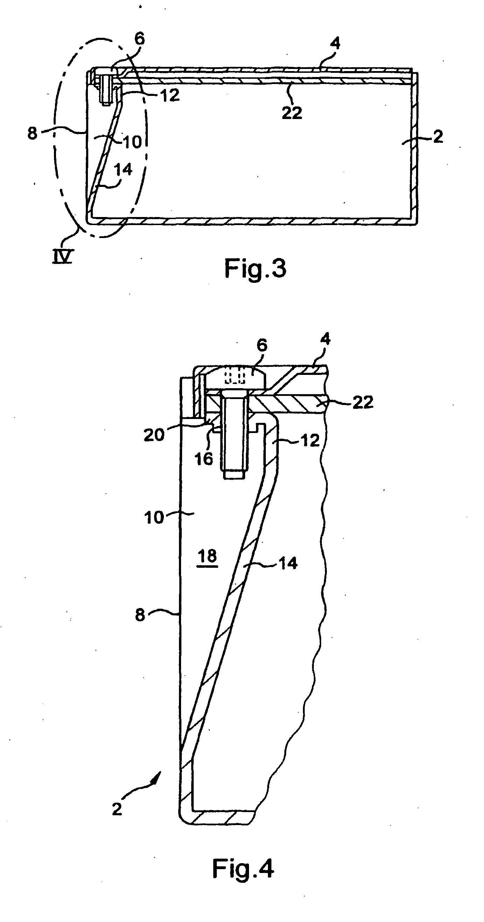

La figure 3 est une vue en coupe selon la ligne de coupe III-III de la figure 2, et
La figure 4 montre à échelle agrandie le détail IV de la figure 3.

On reconnaît sur le dessin un boîtier 2 fermé par un capot 4. Ce boîtier 2 et le capot 4 correspondant sont par exemple réalisés en tôle. Des vis 6 sont utilisées pour le maintien du capot 4 sur le boîtier 2. On utilise ici de préférence des vis autoformeuses qui permettent une excellente fixation sans utiliser d'écrous. De telles vis sont conçues pour générer elles-mêmes leur taraudage lors de leur premier vissage dans un alésage 16 adapté.

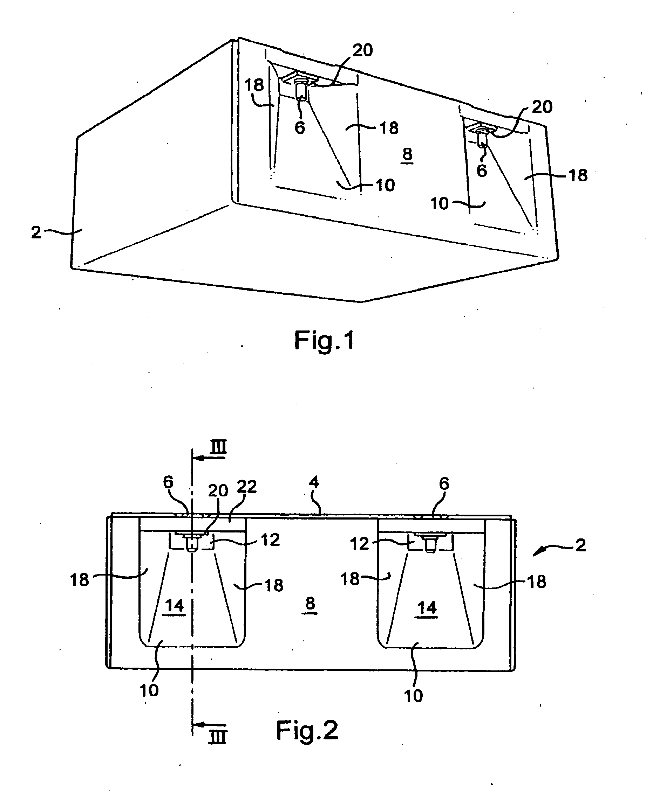

La figure 2 montre une paroi latérale 8 du boîtier 2. Le capot 4 est positionné perpendiculairement à cette paroi latérale 8. Au niveau de chaque vis 6, la paroi latérale 8 présente une zone en creux 10. Cette zone en creux 10 présente un fond en deux parties. Une première partie 12 est sensiblement parallèle à la paroi latérale 8. Cette première partie 12 se trouve du côté de la vis 6 correspondante et s'étend sur une hauteur sensiblement égale à la longueur de la tige de la vis 6 ayant traversé l'alésage 16 portant la vis 6 autoformeuse. La seconde partie 14 du fond de la zone en creux 10 est sensiblement plane. Elle relie la paroi latérale 8 à la première partie 12, parallèle à la paroi latérale 8 mais décalée par rapport à celle-ci vers l'intérieur du boîtier 2. Cette seconde partie 14 du fond de la zone en creux 10 forme ainsi un plan incliné qui pénètre progressivement vers l'intérieur du boîtier 2 au fur et à mesure qu'il se rapproche de la vis 6 autoformeuse.

Le fond de la zone en creux 10 est également relié à la paroi latérale 8 par des faces de liaison 18. Ces dernières peuvent être sensiblement perpendiculaires à la paroi latérale 8 ou, comme représenté sur le dessin, être elles aussi inclinées, la zone en creux 10 se présentant alors comme une cuvette.

On suppose dans la suite de la description que le boîtier 2 est disposé de telle sorte que la paroi latérale 8 se trouve dans une position sensiblement verticale et que le capot 4 est disposé sensiblement horizontalement sur le haut du boîtier 2.

La zone en creux est surplombée par un rebord 20 sensiblement perpendiculaire à la paroi latérale 8. Ce rebord 20 est rattaché à la première partie 12 du fond de la zone en creux 10 et forme un angle droit avec celle-ci. Ce rebord 20 porte l'alésage 16 recevant la vis 6 autoformeuse. Le rebord 20 forme ainsi sur le haut du boîtier 2 une surface d'appui pour le capot 4. Dans la forme de réalisation représentée au dessin, on remarque qu'un circuit imprimé 22 est pris en sandwich entre le rebord 20 et le capot 4. Ce circuit imprimé 22 porte des composants électroniques non représentés au dessin.

Lors du montage de ce boîtier 2, le circuit imprimé 22 est posé sur le haut du boîtier 2 puis est recouvert par le capot 4. Des alésages faisant face aux alésages 16 des rebords 20 du boîtier 2 sont prévus dans le circuit imprimé 22 et dans le capot 4. Ces alésages réalisés dans le capot 4 et le circuit imprimé 22 sont d'un diamètre supérieur au diamètre de la tige de la vis 6. Lors du montage, la vis 6 traverse donc ces alésages et est arrêtée au niveau de l'alésage 16 dont le diamètre initial est inférieur au diamètre de la tige de la vis 6. Par vissage, la vis taraude l'alésage 16 et forme une cheminée taraudée permettant l'accrochage de la vis 6. Lors de la formation de cette cheminée, des copeaux métalliques sont généralement formés. Ces copeaux tombent alors par gravité sur la seconde partie 14 du fond de la zone en creux 10. Cette seconde partie 14 forme alors un toboggan évacuant les copeaux ainsi formés. Ces copeaux ne risquent plus de venir créer des courts-circuits à l'intérieur du boîtier 2.

Dans cette forme de réalisation, les tiges de vis 6 se retrouvent à l'extérieur du boîtier. Toutefois, par rapport à un boîtier similaire de l'art antérieur, les dimensions extérieures du boîtier ne varient pas. Le prix de revient d'un boîtier selon l'invention est sensiblement le même que celui d'un boîtier de l'art antérieur. Le boîtier selon l'invention permet donc, sans surcoût, d'éviter de manière fiable les problèmes de courts-circuits (ou autres problèmes électriques) dus à la chute de copeaux sur un circuit imprimé ou à proximité d'un composant.

La présente invention ne se limite pas à la forme de réalisation préférentielle décrite ci-dessus à titre d'exemple non limitatif. Elle concerne également toutes les variantes de réalisation à la portée de l'homme du métier dans le cadre des revendications ci-après.

Ainsi, les formes, aussi bien du boîtier, de son capot que de la zone en creux, peuvent être modifiées sans sortir du cadre de l'invention.

Le montage du circuit imprimé en sandwich entre le rebord du boîtier et le capot est optionnel. On peut par exemple prévoir de fixer le capot directement sur le boîtier. On peut aussi envisager que le circuit imprimé forme le capot du boîtier. Les vis de fixation peuvent aussi être utilisées pour la fixation d'éléments autres qu'un couvercle, capot ou similaire.

## Revendications

1. Boîtier métallique- (2), notamment boîtier (2) destiné à contenir des composants électroniques ou similaires, comportant une paroi latérale (8) munie d'un rebord (20) présentant un alésage (16) pour recevoir une vis (6) de fixation, **caractérisé en ce que** la paroi latérale (8) présente, au niveau de l'alésage (16), une zone en creux (10) dont la concavité est orientée vers l'extérieur du boîtier (2), ladite zone en creux étant adaptée pour permettre une évacuation d'éventuels copeaux métalliques vers l'extérieur du boîtier lors du vissage de la vis de fixation, le rebord (20) étant destiné à recevoir la vis (6) surplombant la zone en creux (10).

2. Boîtier selon la revendication 1, **caractérisé en ce que** la paroi latérale (8) est sensiblement plane et **en ce que** le rebord (20) surplombant ne traverse pas le plan de la paroi (8).

3. Boîtier selon l'une des revendications 1 ou 2, **caractérisé en ce que** la paroi latérale (8) est sensiblement plane et **en ce que** le rebord (20) surplombant est sensiblement perpendiculaire au plan de la paroi (8).

4. Boîtier selon l'une des revendications 1 à 3, **caractérisé en ce que** la paroi latérale (8) est sensiblement plane et **en ce que** la zone en creux (10) présente une surface (14) inclinée par rapport au plan de la paroi latérale (8) de manière à évacuer vers l'extérieur du boîtier (2) d'éventuels copeaux produits par le vissage de la vis (6) de fixation.

5. Boîtier selon les revendications 3 et 4, **caractérisé en ce que** la surface (14) Inclinée est raccordée au rebord (20) surplombant par une portion de paroi (12) sensiblement parallèle à la paroi latérale (8).

6. Boîtier selon l'une des revendications 1 à 5, **caractérisé en ce qu'**il comporte un capot (4) formant couvercle, **en ce que** les composants électroniques ou similaires sont portés par un circuit imprimé (22), et **en ce que** le bord périphérique du circuit imprimé (22) est pris en sandwich entre le capot (4) et le rebord (20) destiné à recevoir la vis (6) de fixation, cette dernière traversant le circuit imprimé (22).

## Claims

1. Metal housing (2), particularly a housing (2) intended to contain electronic or similar components, comprising a side wall (8) furnished with a ledge (20) having a bore (16) to receive a fixing screw (6), **characterised in that** the side wall (8) has, at the bore (16), a recessed area (10) whose concavity is oriented toward the outside of the housing (2), said recessed zone being suitable for allowing a discharge of any metal chips toward the outside of the housing when the fixing screw is screwed in, the ledge (20) being intended to receive the screw (6) overhanging the recessed zone (10).

2. Housing according to claim 1, **characterised in that** the side wall (8) is substantially flat and **in that** the overhanging ledge (20) does not cross the plane of the wall (8).

3. Housing according to one of claims 1 or 2, **characterised in that** the side wall (2) is substantially flat and **in that** the overhanging ledge (20) is substantially perpendicular to the plane of the wall (8).

4. Housing according to one of claims 1 to 3, **characterised in that** the side wall (8) is substantially flat and **in that** the recessed zone (10) has a surface (14) inclined relative to the plane of the side wall (8) so as to discharge toward the outside of the housing (2) any chips produced by the screwing of the fixing screw (6).

5. Housing according to claims 3 and 4, **characterised in that** the inclined surface (14) is connected to the overhanging ledge (20) by a portion of wall (12) substantially parallel to the side wall (8).

6. Housing according to one of claims 1 to 5, **characterised in that** it comprises a cap (4) forming a cover, **in that** the electronic or similar components are supported by a printed circuit (22), and **in that** the peripheral edge of the printed circuit (22) is sandwiched between the cap (4) and the ledge (20) intended to receive the fixing screw (6), the latter traversing the printed circuit (22).

## Patentansprüche

1. Metallgehäuse (2), insbesondere Gehäuse (2) zur Aufnahme von elektronischen Bauteilen oder dergleichen, umfassend eine Seitenwand (8), die mit einem Rand (20) ausgestattet ist, der eine Bohrung (16) zum Aufnehmen einer Befestigungsschraube (6) aufweist, **dadurch gekennzeichnet, dass** die Seitenwand (8) auf Höhe der Bohrung (16) einen Hohlbereich (10) aufweist, dessen Konkavität in Richtung Äußeres des Gehäuses (2) ausgerichtet ist, wobei der Hohlbereich angepasst ist, um beim Festschrauben der Befestigungsschraube ein Abführen eventueller Metallspäne in Richtung Äußeres des Gehäuses zu ermöglichen, wobei der Rand (20) zum Aufnehmen der Schraube (6) bestimmt ist, die über den Hohlbereich (10) hervorragt.

2. Gehäuse nach Anspruch 1, **dadurch gekennzeichnet, dass** die Seitenwand (8) im Wesentlichen eben ist und **dadurch**, dass der hervorragende Rand (20) die Ebene der Wand (8) nicht durchquert.

3. Gehäuse nach einem der Ansprüche 1 oder 2, **dadurch gekennzeichnet, dass** die Seitenwand (8) im Wesentlichen eben ist und **dadurch**, dass der hervorragende Rand (20) im Wesentlichen senkrecht zur Ebene der Wand (8) verläuft.

4. Gehäuse nach einem der Ansprüche 1 bis 3, **dadurch gekennzeichnet, dass** die Seitenwand (8) im Wesentlichen eben ist und **dadurch**, dass der Hohlbereich (10) eine Oberfläche (14) aufweist, die in Bezug auf die Ebene der Seitenwand (8) so geneigt ist, dass eventuelle Späne, die durch das Festschrauben der Befestigungsschraube (6) entstehen, in Richtung Äußeres des Gehäuses (2) abgeführt werden.

5. Gehäuse nach Anspruch 3 und 4, **dadurch gekennzeichnet, dass** die geneigte Oberfläche (14) mit dem hervorragenden Rand (20) durch einen Wandteil (12) verbunden ist, der im Wesentlichen parallel zur Seitenwand (8) verläuft.

6. Gehäuse nach einem der Ansprüche 1 bis 5, **dadurch gekennzeichnet, dass** es eine Abdeckung (4) umfasst, die einen Deckel bildet; **dadurch**, dass die elektronischen Bauteile oder dergleichen von einer Leiterplatte (22) getragen werden; und **dadurch**, dass der umlaufende Rand der Leiterplatte (22) zwischen der Abdeckung (4) und dem Rand (20) zum Aufnehmen der Befestigungsschraube (6) eingeklemmt ist, wobei Letztere die Leiterplatte (22) durchquert.
